(19) **Europäisches Patentamt**
**European Patent Office**
**Office européen des brevets**

(11) **EP 3 674 996 B1**

(12) **FASCICULE DE BREVET EUROPEEN**

(45) Date de publication et mention
de la délivrance du brevet:
**04.06.2025 Bulletin 2025/23**

(51) Classification Internationale des Brevets (IPC):
**G06N 5/01** (2023.01) **G06N 10/20** (2022.01)
**G06N 10/60** (2022.01)

(21) Numéro de dépôt: **19219564.2**

(52) Classification Coopérative des Brevets (CPC):
**G06N 10/20; G06N 5/01; G06N 10/60**

(22) Date de dépôt: **23.12.2019**

(54) **MÉTHODE DE DÉVELOPPEMENT D'UN PROCÉDÉ DE COMPILATION D'UN CIRCUIT QUANTIQUE SUR UN PROCESSEUR QUANTIQUE ET UN TEL PROCÉDÉ**

ENTWICKLUNGSMETHODE EINES KOMPILIERUNGSVERFAHRENS EINES QUANTENSCHALTKREISES AUF EINEM QUANTENPROZESSOR, UND ENTSPRECHENDES VERFAHREN

METHOD FOR THE DEVELOPMENT OF A METHOD FOR COMPILATION OF A QUANTUM CIRCUIT ON A QUANTUM PROCESSOR AND SUCH A METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.12.2018 FR 1874179**

(43) Date de publication de la demande:
**01.07.2020 Bulletin 2020/27**

(73) Titulaire: **Bull SAS**
**78340 Les Clayes-sous-Bois (FR)**

(72) Inventeurs:
• **MARTIEL, Simon**
**95870 Bezons (FR)**
• **GAZDA, Arnaud**
**95870 Bezons (FR)**

(74) Mandataire: **Plasseraud IP**
**104 Rue de Richelieu**
**CS92104**
**75080 Paris Cedex 02 (FR)**

(56) Documents cités:
• **THOMAS HÄNER ET AL: "A software methodology for compiling quantum programs", QUANTUM SCIENCE AND TECHNOLOGY, vol. 3, no. 2, 21 February 2018 (2018-02-21), pages 020501, XP055612173, DOI: 10.1088/2058-9565/ aaa5cc**

• **MASLOV D ET AL: "Quantum Circuit Simplification and Level Compaction", ARXIV.ORG, CORNELL UNIVERSITY LIBRARY, 201 OLIN LIBRARY CORNELL UNIVERSITY ITHACA, NY 14853, 27 February 2008 (2008-02-27), XP080235665, DOI: 10.1109/ TCAD.2007.911334**

• **ALWIN ZULEHNER ET AL: "Compiling SU(4) ) antum Circuits to IBM QX Architectures", CORR (ARXIV), vol. 1808.05661, no. v2, 5 November 2018 (2018-11-05), pages 1 - 6, XP055637837**

• **ESTEBAN A MARTINEZ ET AL: "Compiling quantum algorithms for architectures with multi-qubit gates", NEW JOURNAL OF PHYSICS, INSTITUTE OF PHYSICS PUBLISHING, BRISTOL, GB, vol. 18, no. 6, 24 June 2016 (2016-06-24), pages 63029, XP020304457, ISSN: 1367-2630, [retrieved on 20160624], DOI: 10.1088/1367-2630/ 18/6/063029**

• **MONA ARABZADEH ET AL: "Rule-based optimization of reversible circuits", DESIGN AUTOMATION CONFERENCE (ASP-DAC), 2010 15TH ASIA AND SOUTH PACIFIC, IEEE, PISCATAWAY, NJ, USA, 18 January 2010 (2010-01-18), pages 849 - 854, XP031641265, ISBN: 978-1-4244-5765-6**

• **GUSHU LI ET AL: "Tackling the Qubit Mapping Problem for NISQ-Era Quantum Devices", ARXIV.ORG, CORNELL UNIVERSITY LIBRARY, 201 OLIN LIBRARY CORNELL UNIVERSITY ITHACA, NY 14853, 7 September 2018 (2018-09-07), XP081080306**

**(Cont. page suivante)**

- **MEHDI SAEEDI ET AL: "Synthesis and Optimization of Reversible Circuits - A Survey",** ARXIV.ORG, CORNELL UNIVERSITY LIBRARY, 201 OLIN LIBRARY CORNELL UNIVERSITY ITHACA, NY 14853, 12 October 2011 (2011-10-12), XP080532458, DOI: 10.1145/2431211.2431220
- **MATTHEW AMY ET AL: "Algorithms for the optimization of quantum circuits",** THESIS FOR MMATH IN COMPUTER SCIENCE AT UNIVERSITY OF WATERLOO, 30 August 2013 (2013-08-30), XP055249749, Retrieved from the Internet <URL:http://hdl.handle.net/10012/7818> [retrieved on 20160212]
- **WILL FINIGAN ET AL: "Qubit Allocation for Noisy Intermediate-Scale Quantum Computers",** ARXIV.ORG, CORNELL UNIVERSITY LIBRARY, 201 OLIN LIBRARY CORNELL UNIVERSITY ITHACA, NY 14853, 19 October 2018 (2018-10-19), XP081067707
- **SUMEET KHATRI ET AL: "Quantum-assisted quantum compiling",** ARXIV.ORG, CORNELL UNIVERSITY LIBRARY, 201 OLIN LIBRARY CORNELL UNIVERSITY ITHACA, NY 14853, 2 July 2018 (2018-07-02), XP081202876

**Description**

**Domaine technique**

L'invention relève du domaine des méthodes de développement d'un procédé de compilation d'un circuit quantique pour un processeur quantique.

**Technique antérieure**

Il est connu du document *Compiling SU(4) Quantum Circuits to IBM QX Architectures* une méthode permettant de compiler un programme quantique pour un processeur quantique fixé. La méthode ne considère que certains changements comme l'insertion de portes quantiques de permutation de valeur entre deux qbits et une décomposition de Cartan. La méthode cherche à minimiser le nombre de portes quantiques dans le circuit quantique résultant, en utilisant une heuristique.

Toutefois, cette méthode ne permet pas de compiler n'importe quel programme quantique sur n'importe quel processeur quantique. De plus, cette méthode n'est pas une méthode « à tout moment » (ou « anytime » en anglais).

Il est également connu du document Rule-based optimization of reversible circuits une méthode permettant de remplacer des sous-circuits quantiques par des sous-circuits quantiques équivalents optimaux.

Toutefois, cette méthode ne s'applique que pour des sous-circuits réversibles, et présente de fait des contraintes importantes.

D'autres exemples et modes de réalisation de l'art antérieur peuvent être trouvés dans :

- Häner et al: "A software methodology for compiling quantum programs", Quantum Science and Technology, vol. 3, no. 2, 21 février 2018, page 020501 ;
- Maslov et al: "Quantum Circuit Simplification and Level Compaction", arxiv.org, Cornell University Library, 201 Olin Library Cornell University Ithaca, NY 14853, 27 février 2008 ;
- Zulehner et al: "Compiling SU(4) Quantum Circuits to IBM QX Architectures", Corr (Arxiv), vol. 1808.05661, no. v2, 5 novembre 2018, pages 1-6 ;
- Martinez et al: "Compiling quantum algorithms for architectures with multi-qubit gates", New Journal of Physics, Institute of Physics Publishing, Bristol, GB, vol. 18, no. 6, 24 juin 2016, page 63029 ;
- Li et al: "Tackling the Qubit Mapping Problem for NISQ-Era Quantum Devices", arxiv.org, Cornell University Library, 201 Olin Library Cornell University Ithaca, NY 14853, 7 septembre 2018 ;
- Saeedi et al: "Synthesis and Optimization of Reversible Circuits - A Survey", arxiv.org, Cornell University Library, 201 Olin Library Cornell University Ithaca, NY 14853, 12 octobre 2011 ;
- Amy et al: "Algorithms for the optimization of quantum circuits", Thesis, University of Waterloo, 30 août 2013;

- Will Finigan et al.: "Qubit Allocation for Noisy Intermediate-Scale Quantum Computers", arxiv.org, Cornell University Library, 201 Olin Library Cornell University Ithaca, NY 14853, 19 octobre 2018;
- Sumeet Khatri et al.: "Quantum-assisted quantum compiling", arxiv.org, Cornell University Library, 201 Olin Library Cornell University Ithaca, NY 14853, 2 juillet 2018.

**Problème technique**

Ces solutions connues ne permettent pas d'une part, de proposer une méthode capable de compiler un circuit quantique quelconque sur un processeur quantique quelconque, et, d'autre part, de permettre, lors de la compilation d'un circuit quantique, de proposer une méthode d'optimisation du circuit quantique selon l'invention exposée dans le jeu de revendications joint.

L'invention vient pallier au moins partiellement les inconvénients de l'art antérieur.

Pour cela, l'invention propose une méthode permettant la compilation de tout circuit quantique pour tout processeur quantique, tout en permettant l'optimisation de la compilation du circuit quantique. Pour cela, il va être intéressant de proposer une étape de sélection d'une pluralité de paramètres comprenant le circuit quantique, le processeur quantique, et un jeu de portes quantiques.

La méthode permet donc une compilation avec trois degrés de liberté, rendant ainsi cette méthode particulièrement adaptable, tant en termes de compilation de circuits quantiques, qu'en termes d'optimisation du circuit quantique obtenu.

Pour autoriser autant de liberté sans sacrifier l'efficacité du circuit quantique, l'invention propose d'une part de réécrire le circuit quantique sous-circuit par sous-circuit, et d'autre part de d'abord convertir les portes non-exécutables en porte exécutables avant d'optimiser les portes exécutables selon une métrique de réduction du nombre de portes quantiques.

Il est proposé une méthode de développement d'un procédé de compilation d'un circuit quantique pour un processeur quantique, telle que définie dans la revendication 1.

Dans la deuxième étape de réécriture des sous-circuits quantiques, des portes quantiques pouvant être améliorées, par exemple fusion de deux portes quantiques en une seule, peuvent également être remplacées. Cette étape d'amélioration, si elle « strictement meilleure localement », pourra être réalisée entre les première et deuxième étapes de réécriture. On cherchera à obtenir des portes exécutables et optimales, c'est-à-dire des portes exécutables qui sont « strictement meilleures localement », i.e. s'il existe une optimisation triviale (par exemple fusionner deux portes : « RX(x) - RX(y) → RX(x+y) » dans l'hypothèse où l'on sait exécuter n'importe quel RX, l'amélioration est évidente) on pourra effectuer cette optimisation triviale dès que possible ou à tout moment.

Par « portes quantiques non exécutables », on entend des portes quantiques qui ne peuvent pas être exécutées sur le processeur quantique sélectionné, ou des portes quantiques que l'on souhaite voir disparaître.

De préférence, le recuit simulé réécrit les sous-circuits quantiques comme défini dans la revendication 2.

Il pourrait aussi être envisagé de remplacer des portes quantiques à n qbits par des portes quantiques à n-p qbits, par exemple des portes quantiques à 4 ou 5 qbits, par des portes quantiques à 2 ou 3 qbits.

Le recuit simulé est également apte à réécrire les sous-circuits quantiques en remplaçant des portes quantiques à deux qubits ou plus de deux qubits par des portes quantiques à un qubit, à deux qubits, ou à plus de deux qubits.

Le recuit simulé est donc apte à effectuer différentes opérations de réécritures, permettant ainsi d'augmenter la métrique de réduction du nombre de portes quantiques.

Il apparaît en effet que l'utilisation d'un recuit simulé en tant qu'heuristique ou métaheuristique donne les meilleurs résultats en termes d'optimisation du circuit quantique et augmentation de la métrique de réduction du nombre de portes quantiques.

L'utlisation d'un recuit simulé, pour optimiser un circuit quantique de manière à ce qu'il comporte le moins de portes quantiques possible, est particulièrement avantageuse. Notamment, ce choix de métrique et de l'heuristique ou la métaheuristique mène vers une compilation particulièrement efficace du circuit quantique, le recuit simulé étant idéal lorsqu'il s'agit d'obtenir un circuit quantique ayant un nombre réduit de portes quantiques. En effet, cette technique de recuit simulé, grâce à sa possibilité de désoptimisation locale pour une meilleure optimisation globale, permet d'obtenir plus facilement et plus sûrement un optimum global plutôt que de rester à un simple optimum local proche de la configuration initiale du circuit quantique, ce qui serait plus difficile avec d'autres heuristiques comme par exemple la descente de gradient. Par ailleurs, cette méthode peut toujours être appliquée à n'importe quel circuit quantique sur n'importe quel processeur quantique.

L'utilisation d'une boucle d'itérations lors de l'application du recuit simulé permet de pouvoir effectuer des désoptimisations locales pour obtenir finalement une optimisation globale du circuit quantique. Autrement dit, le recuit simulé se permet de ne pas effectuer des optimisations locales aveugles, optimisations locales risquant finalement de ne pas mener au circuit quantique le plus optimal. Ainsi, en choisissant parfois d'augmenter localement la métrique au lieu de la réduire systématiquement, le recuit simulé mène à une optimisation globale du circuit quantique plus importante.

De préférence, le seuil maximal d'itérations dans la boucle est prédéterminé en fonction au moins du processeur quantique et/ou du circuit quantique sélectionnés.

Cela permet de limiter le nombre d'itérations lorsqu'un seuil de la métrique est atteint. Par ailleurs, la méthode étant une méthode « anytime », il est possible d'interrompre la boucle d'itérations à tout moment tout en obtenant un circuit quantique optimisé.

De préférence, un score égal à moins l'infini est associé aux portes quantiques non exécutables sur le processeur quantique sélectionné,
un score égal à zéro ou à une autre valeur constante est associé aux portes quantiques exécutables sur le processeur quantique sélectionné.

En variante, un autre score peut être associé aux portes quantiques non exécutables. Ce score est par exemple strictement inférieur au score associé aux portes quantiques exécutables. Le score égal à moins l'infini permet de détecter immédiatement qu'une porte non exécutable est présente dans le circuit quantique.

## Brève description des dessins

D'autres caractéristiques, détails et avantages de l'invention apparaîtront à la lecture de la description détaillée ci-après, et à l'analyse des dessins annexés, sur lesquels :

**Fig. 1**

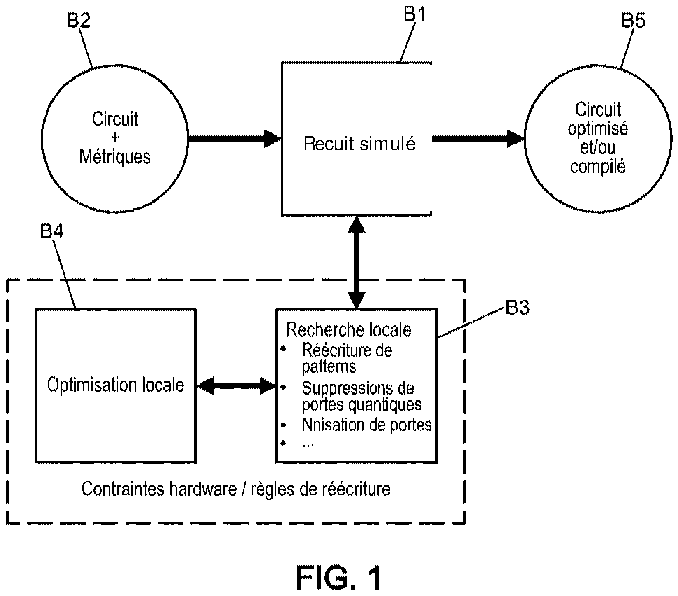

[Fig. 1] illustre un schéma bloc mis en œuvre par la méthode de développement d'un procédé de compilation d'un circuit quantique sur un processeur quantique selon un mode de réalisation de l'invention.
**Fig. 2a**

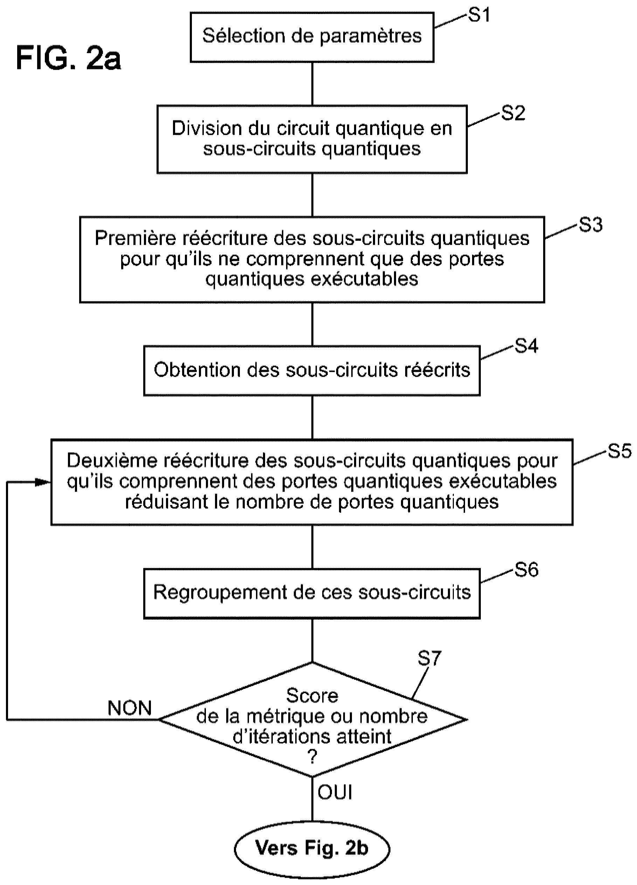

[Fig. 2a] illustre les principales étapes de la méthode de développement d'un procédé de compilation d'un circuit quantique pour un processeur quantique selon un mode de réalisation de l'invention.

**Fig. 2b**

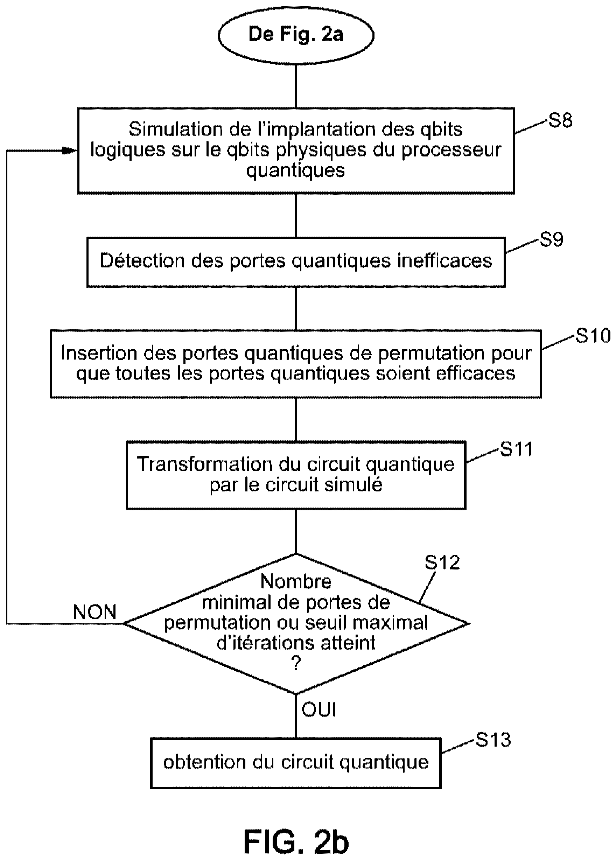

[Fig. 2b] illustre les principales étapes de la méthode de développement d'un procédé de compilation d'un circuit quantique pour un processeur quantique selon un mode de réalisation de l'invention.

**Fig. 3**

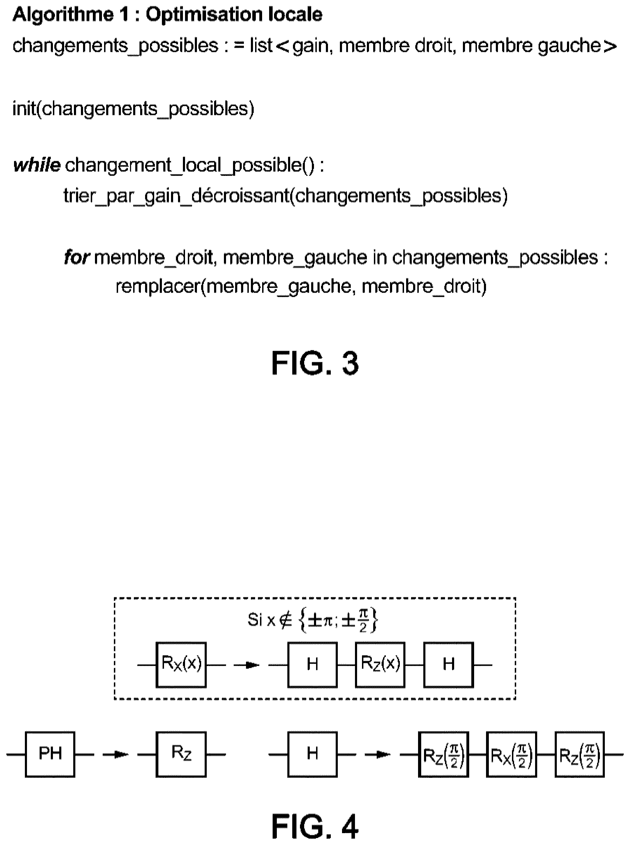

[Fig. 3] montre un pseudo code utilisé pour l'optimisation locale d'un circuit quantique selon la méthode de développement d'un procédé de compilation d'un circuit quantique pour un processeur quantique selon un mode de réalisation de l'invention.

**Fig. 4**

[Fig. 4] montre un exemple de règles utilisées pour la réécriture d'un circuit quantique selon la méthode de développement d'un procédé de compilation d'un circuit quantique pour un processeur quantique selon un mode de réalisation de l'invention.

**Fig. 5**

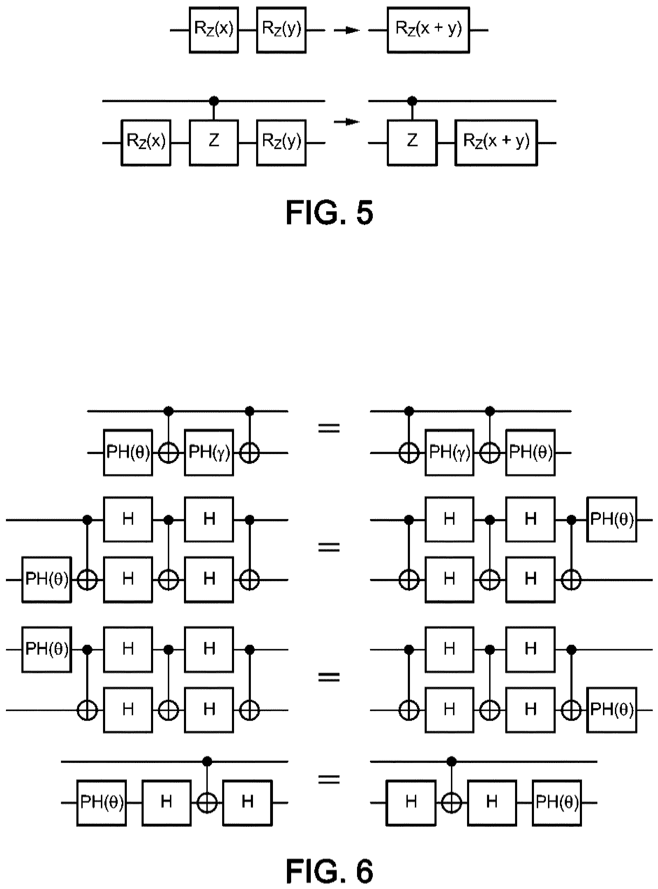

[Fig. 5] montre un exemple de règles utilisées pour la réécriture d'un circuit quantique selon la méthode de développement d'un procédé de compilation d'un circuit quantique pour un processeur quantique selon un mode de réalisation de l'invention.

**Fig. 6**

[Fig. 6] montre un exemple de règles utilisées pour la réécriture d'un circuit quantique selon la méthode de développement d'un procédé de compilation d'un circuit quantique pour un processeur quantique selon un mode de réalisation de l'invention

**Fig. 7**

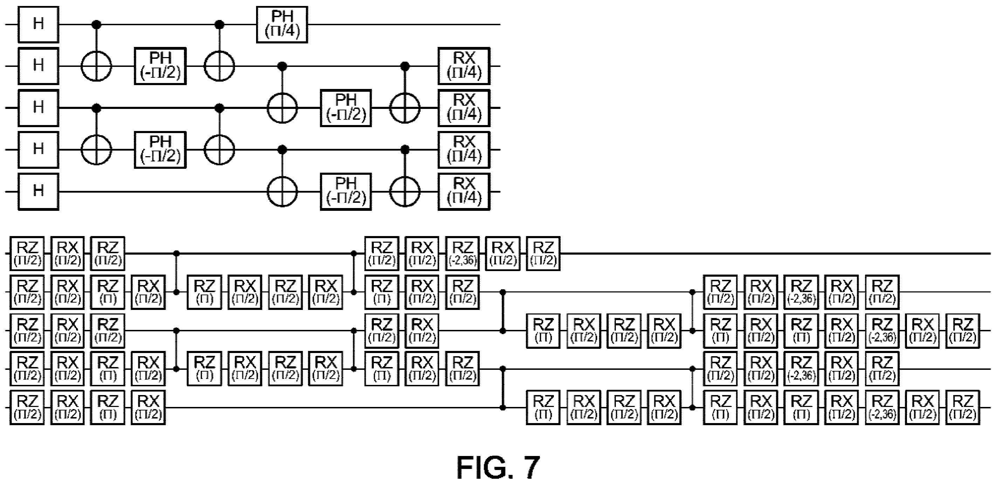

[Fig. 7] montre un exemple de circuit quantique compilé à partir d'un circuit original selon un exemple de règles utilisées pour la réécriture d'un circuit quantique selon la méthode de développement d'un procédé de compilation d'un circuit quantique pour un processeur quantique selon un mode de réalisation de l'invention.

**Fig. 8**

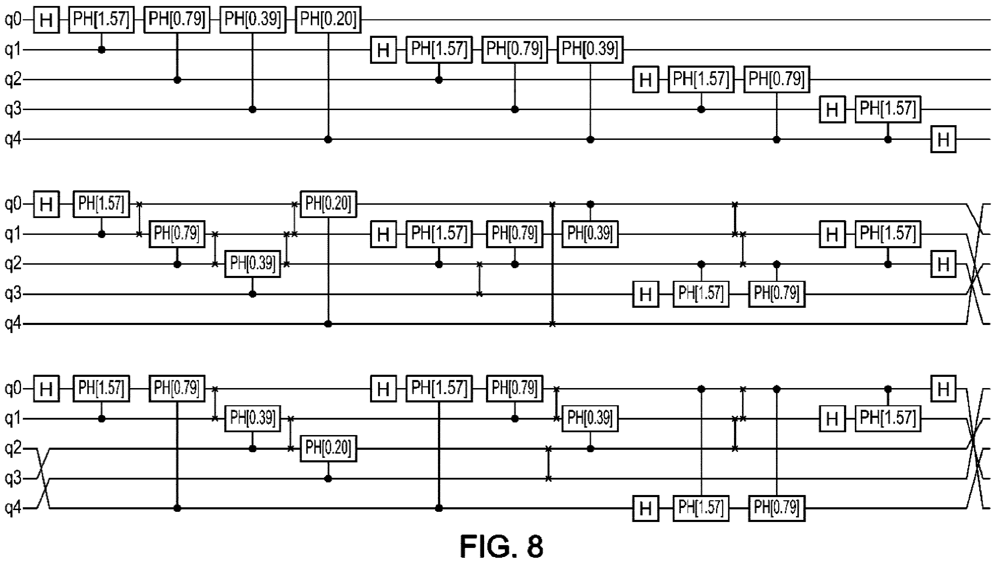

[Fig. 8] montre un autre exemple de circuit quantique compilé à partir d'un circuit original selon un exemple de règles utilisées pour la réécriture d'un circuit quantique selon la méthode de développement d'un procédé de compilation d'un circuit quantique pour un processeur quantique selon un mode de réalisation de l'invention.

**Description des modes de réalisation**

Il est maintenant fait référence à la figure 1. La méthode selon l'invention permet de compiler tout circuit quantique sur tout processeur quantique.

Pour ce faire, il s'agit de résoudre le problème suivant :

[Math. 1]

$$\underset{C' \sim_R C}{\operatorname{argmax}} f(C')$$

Où $f$ est une métrique sélectionnable et $\sim_R$ est une relation binaire telle que :

[Math. 2]

$$C' \sim_R C \Leftrightarrow \text{"} C' \text{ peut être obtenu à partir de } C \text{ par changement locaux}$$

Une transformation $\rightarrow_L$ peut en outre être définie, telle que :

[Math. 3]

$$\rightarrow_L : \mathcal{C} \rightarrow \mathcal{P}(\mathcal{C})$$

Avec $C$ un ensemble de circuits quantiques.

Le problème peut donc être réécrit tel que

[Math. 4]

$$\underset{C'}{\arg\max} \ \{f(C')|\ C \to_L^* C'\}.$$

La méthode selon l'invention permet de sélectionner la métrique f voulue, et des changements locaux $\to_L$ quelconques.

Plus précisément, les changements locaux permettent de définir des règles de réécriture du circuit quantique pour qu'il puisse être compilé pour un processeur quantique sélectionné. Les changements locaux sont par exemple un jeu de portes quantiques exécutables sur le processeur quantique sélectionné.

Les changements locaux peuvent en outre comprendre des règles d'optimisation, telles que l'insertion de portes quantiques de permutation, tel que décrit ci-après.

La méthode utilise notamment un recuit simulé, illustrée par le bloc B1 de la figure 1.

Le recuit simulé reçoit en entrée un circuit quantique sélectionné et une métrique globale, illustré par le bloc B2. La métrique globale est sélectionnée pour diminuer le nombre de portes quantiques dans le circuit quantique compilé obtenu. Le recuit simulé visse à maximiser la métrique globale sélectionnée.

Pour cela, le recuit simulé reçoit en outre en entrée des sous-circuits quantiques fournis par une recherche locale, correspondant au bloc B3.

La recherche locale reçoit elle-même en entrée le circuit quantique sélectionné. La recherche locale est apte à effectuer une séparation du circuit quantique en une pluralité de sous-circuits et de déterminer des sous-circuits quantiques équivalents.

Un sous-circuit quantique équivalent correspond à un sous-circuit quantique différent mais qui produit les mêmes effets, notamment en ce qui concerne des opérations quantiques.

Les sous-circuits équivalents sont déterminés en fonction des changements locaux autorisés, tels que des modifications de portes quantiques non exécutables par le processeur quantique sélectionné en portes quantiques exécutables par ce processeur quantique.

Plus précisément, la recherche locale B3 une opération de modification locale du circuit quantique. Plus précisément, un sous-circuit quantique est remplacé par un sous-circuit quantique équivalent sans considérer le circuit quantique dans sa globalité.

Cette modification est donc peu coûteuse au vue de la taille du circuit quantique.

A l'issu de cette modification, un nombre limité de sous-circuits est retourné au recuit simulé car la recherche locale B3 n'autorise que certains changements de sous-circuits, définis par les changements locaux sélectionnés. La recherche locale permet donc d'acceler le recuit simulé.

Toutefois, ces réécritures du circuit quantique en sous-circuits quantiques équivalents peuvent mener à une dégradation de la métrique globale.

Ainsi, une optimisation locale peut être mise en œuvre par le bloc B4. L'optimisation locale détecte les sous-circuits quantiques non optimaux. Un sous-circuit quantique est non optimal s'il existe un sous-circuit quantique équivalent strictement meilleur. L'optimisation locale vise à remplacer les sous-circuits quantiques non optimaux par les sous-circuits quantiques optimaux.

L'optimisation locale utilise un score noté *l*. Pour un sous-circuit quantique, plus le score est élevé, plus le sous-circuit quantique est optimal.

Le circuit quantique est à modifier pour qu'il ne contienne que des sous-circuits optimaux tels que :

[Math. 5]

$$\forall\ C_1, C_2 \in \mathcal{C}^2, \text{if}\ C_1 \to_L C_2 \text{ and } l(C_1) \leq l(C_2) \text{ puis } C_1 \to C_2$$

L'opérateur $\to$ signifie remplacer les sous-circuits $C_1$ par $C_2$ dans tous les sous-circuits trouvés par la recherche locale.

L'optimisation locale effectue des changements locaux par gain décroissant. Autrement dit, les changements à gains élevés sont effectués en premier. Le gain est défini comme la différence de score entre un sous-circuit quantique et un sous-circuit quantique équivalent :

[Math. 6]

$$gain = score_{local}(membre\ droit) - score_{local}(membre\ gauche)$$

La figure 3 est un pseudo code utilisé pour la mise en œuvre de l'optimisation locale. Dans ce pseudo code, tous les changements locaux sélectionnés sont répertoriés. Pour chaque changement local sélectionné, les gains associé à la réécriture de chaque sous-circuit quantique par un sous-circuit quantique optimal sont calculés et triés afin d'effectuer en premier les réécritures dont le gain associé est le plus élevé.

Ces sous-circuits quantiques optimaux sont ensuite envoyés au recuit simulé (bloc B2) qui réécrit le circuit quantique en remplaçant des sous-circuits quantiques par un sous-circuit quantique optimal dans le but de maximiser la métrique globale. Enfin, au bloc B5 le circuit quantique optimisé et compilé est obtenu.

Il est maintenant fait plus particulièrement référence aux figures 2a et 2b qui illustrent les principales étapes de la méthode de développement d'un procédé selon l'invention

Une étape de sélection S1 est d'abord mise en œuvre. Lors de l'étape de sélection S1, plusieurs éléments sont sélectionnés : un circuit quantique, un processeur quantique sur lequel exécuter le circuit quantique sélectionné, un jeu de protes quantiques exécutables sur le processeur quantique sélectionné.

Par ailleurs les métriques visent, d'une part, à réduire le nombre de portes quantiques global du circuit compilé, et, d'autre part, à réduire plus spécifiquement le nombre de portes quantiques de permutation à insérer dans le circuit quantique pour qu'il soit compilable.

Une étape de division S2 du circuit quantique en sous-circuits quantiques est ensuite effectuée.

Une première étape de réécriture S3 est mise en œuvre sur ces sous-circuits quantiques. Plus précisément, les sous-circuits quantiques comprenant des portes quantiques non exécutables par le processeur quantique sélectionné sont réécrits de manière à ce qu'ils comprennent uniquement des portes quantiques exécutables par le processeur quantique sélectionné.

Les sous-circuits quantiques réécrits sont ainsi obtenus à l'étape d'obtention S4.

La première étape de réécriture des sous-circuits quantiques est mise en œuvre par la recherche locale et l'optimisation locale illustrées par les blocs B3 et B4 de la figure 1.

Une deuxième étape de réécriture S5 des sous-circuits quantiques réécrits est ensuite effectuée. La deuxième étape de réécriture S5 est effectuée par le recuit simulé, et vise à maximiser la métrique globale, définie ici comme une minimisation du nombre de portes quantiques du circuit quantique.

A l'étape de regroupement S6, les sous-circuits quantiques sont regroupés pour obtenir un circuit quantique compilable pour le processeur quantique. Autrement dit, toutes les portes quantiques présentes dans ce circuit quantique peuvent être exécutées par le processeur quantique.

Puis le recuit simulé détermine à l'étape de détermination S7 si les sous-circuits regroupés sont optimaux, c'est-à-dire que le score associé au circuit quantique obtenu à l'étape S6 atteint un seuil prédéterminé, ou si le nombre d'itérations maximal est atteint.

Si ce n'est pas le cas, la deuxième étape de réécriture S5 est de nouveau mise en œuvre afin d'optimiser encore le circuit quantique obtenu.

Les figures 4 à 6 illustrent un exemple de réécriture de sous circuits quantiques. Ainsi, des changements locaux sont définis tels que les sous-circuits quantiques (ou les portes quantiques) exécutables par le processeur et/ou les sous-circuits quantiques (ou les portes quantiques) que l'on souhaite conserver ont un score égal à zéro ou tout autre valeur constante. Les sous-circuits quantiques (ou les portes quantiques) non exécutables par le processeur et/ou les sous-circuits quantiques (ou les portes quantiques) que l'on souhaite voir disparaître ont un score égal à moins l'infini ou à toute autre valeur strictement inférieure au score des sous-circuits quantiques exécutables.

De plus, des combinaisons de portes quantiques exécutables par le processeur quantique peuvent être définies pour remplacer les portes quantiques non exécutables.

Par exemple, la figure 4 illustre un exemple dans lequel le processeur quantique sélectionné est apte à exécuter uniquement des portes quantiques à rotation selon l'axe Z Rz et selon l'axe X Rx. Ainsi, les portes quantiques à rotation selon l'axe X Rx peuvent être remplacées par une combinaison de portes quantiques de Hadamard H, à rotation selon l'axe Z Rz et de Hadamard. Une porte quantique PH peut être remplacée par une porte quantique à rotation selon l'axe Z Rz, etc. Sur la figure 4, tous les membres de gauche possèdent un score égal à moins l'infini et le membre de droite un score égal à zéro. Ainsi, tous les membres de gauche sont remplacés par les membres de droite lors de la première étape de réécriture S3.

Un autre exemple de règles est de changer l'ordre des portes quantiques, comme illustré sur la figure 6, où les portes quantiques sont les mêmes entre les sous-circuits à gauche et à droite de la figure, seules l'ordre des portes quantiques est modifié.

Par ailleurs, afin de respecter la métrique visant à réduire le nombre de portes quantiques, d'autres règles sont respectées. Par exemple, deux portes quantiques identiques qui se succèdent peuvent fusionner pour devenir une unique porte quantique, comme illustré sur la figure 5. Cela permet de maximiser la métrique de réduction du nombre de portes quantiques.

Toutes ces règles sont appliquées par la recherche locale et l'optimisation locale, blocs B3 et B4 afin d'optimiser localement le circuit quantique. Toutefois, les sous-circuits réécrits sont retraités par le recuit simulé (bloc B1) qui, lui, cherche à optimiser la métrique globale du circuit, à savoir réduire le nombre de portes quantiques. Ainsi, lors de l'itération des étapes S5 à S7, le recuit simulé peut choisir de réécrire un sous-circuit diminuant la métrique locale du circuit mais maximisant la métrique globale du circuit quantique. L'utilisation du recuit simulé est donc particulièrement avantageuse.

La figure 6 illustre un circuit quantique compilé optimisé, obtenu en sortie de l'étape de détermination S7. Ce circuit quantique comprend uniquement des portes quantiques exécutables par le processeur quantique sélectionné, soit des portes Rz et Rx, tandis qu'il comprenait initialement des portes quantiques H, CNOT et PH.

Une fois ce circuit quantique compilé et optimisé obtenu, une seconde optimisation peut être mise en œuvre.

Il s'agit de permettre de faire interagir des qubits entre eux. Pour ce faire, il est possible d'échanger la valeur de deux qubits afin de rapprocher les qubits à faire interagir, rendant ainsi l'interaction possible. Des portes de permutation quantique peuvent donc être ajoutées au circuit, afin d'échanger la valeur de deux qubits.

La métrique utilisée vise vise à obtenir un circuit quantique comprenant un minimum de portes quantiques de permutation.

A l'étape S8, la recherche locale (bloc B3) effectue une simulation de l'implémentation des qubits logiques du circuit quantique obtenu à l'étape S7 sur le qubits physiques du processeur quantique sélectionné.

A l'étape S9, cette même recherche locale détecte dans le circuit quantique les portes quantiques inefficaces. Par « inefficaces » on entend que les portes quantiques devant interagir entre deux qbits ne le peuvent pas car les qubits ne sont pas voisins, ou que ce sont des portes quantiques que l'on souhaite voir disparaître.

Une métrique locale peut alors être définie. Notamment le score local d'une porte quantique efficace est défini comme dépendant du nombre de portes quantiques de permutation insérées dans le circuit quantique. Le score peut donc être égal au nombre de portes quantiques de permutation présentes dans le circuit quantique. Une porte quantique agissant sur deux qubits non-voisins a un score local égal à moins l'infini ou strictement inférieur au score associé à une porte quantique efficace.

Cette métrique locale permet de garantir d'avoir un circuit quantique dont toutes les portes quantiques agissent sur deux qubits voisins, et donc que toutes les portes quantiques du circuit quantique sont efficaces.

Il est aussi possible de forcer la métrique locale à traiter les portes dans un ordre particulier (les premières portes en premier par exemple) en changeant légèrement la métrique locale.

De plus, il est possible d'améliorer la méthode en regardant l'impact de la simulation de l'étape de simulation S8 sur les qubits suivants.

Les règles de la métrique permettent de définir où les portes quantiques de permutation peuvent être insérées dans le circuit quantique. Le circuit quantique peut donc être transformé pour rapprocher les qubits d'une porte quantique, c'est à dire insérer une porte de permutation dans le circuit quantique et renuméroter les qubits du circuit quantique puisque les portes de permutation permutent l'ordre des qubits.

A l'étape d'insertion S10, les portes quantiques de permutation sont insérées dans le circuit quantique afin que toutes les portes quantiques du circuit soient efficaces. Une étape de transformation S11 du circuit quantique est ensuite mise en œuvre. Le recuit simulé effectue une optimisation globale du circuit pour respecter la métrique globale, à savoir minimiser le nombre de portes quantiques de permutation. Pour ce faire, des sous-parties du circuit quantique peuvent être réécrites, par exemple en suivant les règles de changements locaux autorisées par le processeur quantique, afin de supprimer des portes quantiques de permutation.

Les portes quantiques de permutation sont insérées par la recherche locale et l'optimisation locale, blocs B3 et B4, afin d'optimiser localement le circuit quantique, en supprimant toutes les portes quantiques inefficaces. Toutefois, le circuit quantique modifié est retraité par le recuit simulé qui, lui, cherche à optimiser la métrique globale du circuit, à savoir réduire le nombre de portes quantiques de permutation. Ainsi, lors de l'itération des étapes S8 à S11, le recuit simulé peut choisir de modifier des portes quantiques du circuit quantique, ce qui peut diminuer la métrique locale du circuit mais maximise finalement la métrique globale du circuit quantique. L'utilisation du recuit simulé est donc également particulièrement avantageuse.

Puis, à l'étape de détermination S12, si un nombre minimal de portes quantiques de permutation est atteint, ou si un nombre maximal d'itérations est atteint, le circuit quantique est retourné. Ce circuit quantique est compilé pour le processeur quantique sélectionné et optimisé.

Si ce n'est pas le cas, la méthode est répétée depuis l'étape de simulation S8.

la figure 8 illustre le circuit quantique aux différentes étapes du circuit. Le premier circuit quantique correspond au circuit quantique obtenu à l'étape de simulation S8. Le deuxième circuit quantique est le circuit quantique obtenu après l'optimisation locale, c'est-à-dire après l'intégration des portes de permutation (étape d'insertion S10). Enfin, le dernier circuit quantique est obtenu après l'optimisation globale du circuit quantique par le recuit simulé qui permet de supprimer deux portes quantiques de permutation, lors de l'étape de transformation S11.

Le tableau ci-dessous illustre le résultat de la méthode selon l'invention dans le cas de la réduction du nombre de portes quantiques de permutation par rapport à un art antérieur (Li et al., 2018), pour une application de transformation de Fourier quantique à 10, 13, 16, 20 qbits.

[Tableau 1]

| Méthodes | Art Antérieur | | Méthode selon l'invention | | |
|---|---|---|---|---|---|
| | Nombre de portes de permutation | Temps (s) | Nombre de portes de permutation | Temps (s) | Nombre de portes de permutation lorsque le procédé est arrêté à 10% du temps |
| QFT 10 | 54 | 0.103 | 20 | 3.52 | 27 |
| QFT 13 | 96 | 0.036 | 32 | 7.23 | 41 |
| QFT 16 | 186 | 0.084 | 62 | 19.32 | 82 |
| QFT 20 | 372 | 0.102 | 103 | 33.46 | 119 |

Il apparaît donc que la minimisation du nombre de portes de permutation avec la méthode selon l'invention est bien plus efficace que la méthode utilisée dans l'art antérieur. Par ailleurs, la méthode selon l'invention étant une méthode « anytime », la méthode peut être interrompue sans perdre l'optimisation déjà effectuée sur le circuit quantique, optimisation déjà bien plus efficace que la méthode de l'art antérieur, même à 10% du temps.

Toutefois, le circuit quantique obtenu comprend plus de portes quantiques que le circuit initial. Cela est dû notamment à l'insertion des portes quantiques de permutation. Il en résulte que les phénomènes de bruit sont amplifiés.

Une des sources de bruit est le temps d'inactivité des qubits.

Afin de réduire l'inactivité des qbits, il est possible de déplacer certaines portes quantiques de manière à ce qu'elles remplissent les zones d'inactivité des qubits.

Le recuit simulé cherche donc à maximiser la métrique globale visant à réduire le temps d'inactivité des qubits du circuit quantique. Les changements locaux autorisés par le processeur quantiques sont définis. Par exemple, de tels changements sont le remplacement de sous-circuits quantiques par un sous-circuit quantique équivalent diminuant le temps d'inactivité des qbits.

Une métrique locale, que la recherche locale et l'optimisation locale cherchent à maximiser, est de réduire le nombre de portes quantiques du circuit quantique.

Ainsi, la recherche locale et l'optimisation locale réécrivent des sous-circuits quantiques afin de réduire localement le nombre de portes quantiques.

Le recuit simulé effectue une transformation du circuit quantique obtenu à partir de ces sous-circuits quantiques afin de maximiser la métrique globale.

**Liste des documents cités**

**Littérature non-brevet**

À toute fin utile, le(s) élément(s) non-brevet(s) suivant(s) est (sont) cité(s) :

- nplcit1 : *Compiling SU(4) Quantum Circuits to IBM QX Architectures;*
- nplcit2 : *Rule-based optimization of reversible circuits.*

**Revendications**

1. Méthode exécutée par ordinateur de développement d'un procédé de compilation d'un circuit quantique pour un processeur quantique, comprenant :

   - une étape de sélection (S1) :

      * d'un circuit quantique,
      * d'un processeur quantique sur lequel exécuter le circuit quantique,
      * d'un jeu de portes quantiques exécutables sur le processeur quantique sélectionné, en fonction du processeur quantique sélectionné,

- une étape de division (S2) du circuit quantique sélectionné en sous-circuits quantiques,
- une première étape de réécriture (S3) des sous-circuits quantiques comprenant des portes quantiques non exécutables par le processeur quantique sélectionné de manière à ce qu'ils comprennent uniquement des portes quantiques exécutables par le processeur quantique sélectionné,
- une deuxième étape de réécriture (S5) des sous-circuits quantiques, par l'application d'un recuit simulé, de manière à obtenir des sous-circuits quantiques comprenant des portes quantiques exécutables par le processeur quantique sélectionné réduisant le nombre de portes quantiques,
- une étape de regroupement (S6) des sous-circuits quantiques en un circuit quantique compilable pour le processeur quantique sélectionné, dans laquelle la deuxième étape de réécriture comprend :
- une boucle d'itérations comprenant successivement :

  * une étape d'obtention (S4) de sous-circuits quantiques issus de la première étape de réécriture (S3),
  * une étape de réécriture (S5) desdits sous-circuits quantiques en sous-circuits quantiques comprenant des portes quantiques exécutables par le processeur quantique et réduisant le nombre de portes quantiques,
  * une étape de regroupement (S6) des sous-circuits quantiques pour obtenir un circuit quantique compilable,
  * une étape de rétroaction, par l'intermédiaire du recuit simulé, entraînant une nouvelle étape de réécriture des sous-circuits quantiques issus de la première étape de réécriture en fonction du nombre de portes quantiques du circuit quantique compilable, jusqu'à atteindre :

    ∘ soit un seuil de score extrémal d'une métrique de réduction du nombre de portes quantiques,
    ∘ soit un seuil maximal d'itérations dans la boucle,

  > une itération des étapes suivantes :

    - une étape de simulation de l'implémentation (S8) des qubits logiques du circuit quantique obtenu à l'étape précédente sur les qubits physiques du processeur quantique sélectionné,
    - une étape de détection (S9) dans le circuit quantique des portes quantiques inefficaces, les portes quantiques inefficaces étant des portes quantiques qui, devant interagir entre deux qubits, ne le peuvent pas, car les qubits ne sont pas voisins,
    - une étape d'insertion (S10) de portes quantiques de permutation dans le circuit quantique afin que toutes les portes quantiques du circuit soient efficaces, c'est-à-dire que le circuit quantique a alors toutes ses portes quantiques agissant sur deux qubits voisins,
    - une étape de transformation (S11) du circuit quantique dans laquelle un recuit simulé effectue une optimisation globale du circuit pour respecter une métrique globale, à savoir minimiser le nombre de portes quantiques de permutation,
    - une étape de détermination (S12), si un nombre minimal de portes quantiques de permutation est atteint, ou si un nombre maximal d'itérations est atteint :

      ∘ si c'est le cas, le circuit quantique obtenu est alors exécutable par le processeur quantique sélectionné,
      ∘ si ce n'est pas le cas, la méthode est répétée depuis l'étape de simulation d'implémentation (S8).

**2.** Méthode de développement d'un procédé de compilation d'un circuit quantique sur un processeur quantique selon la revendication 1, dans laquelle le recuit simulé réécrit les sous-circuits quantiques en :

- changeant l'ordre séquentiel des portes quantiques des sous-circuits quantiques,
- et/ou fusionnant plusieurs portes quantiques en une unique porte quantique,
- et/ou remplaçant des portes quantiques à un qubit ou plus de deux qubits par des portes quantiques à un qubit.


**Patentansprüche**

**1.** Computerimplementierte Methode zur Entwicklung eines Verfahrens zur Kompilierung eines Quantenschaltkreises für einen Quantenprozessor, umfassend:

- einen Schritt der Auswahl (S1):

  * eines Quantenschaltkreises,
  * eines Quantenprozessors, auf dem der Quantenschaltkreis ausgeführt werden soll,

* eines Satzes von Quantengattern, die auf dem ausgewählten Quantenprozessor ausführbar sind, in Abhängigkeit von dem ausgewählten Quantenprozessor,

- einen Schritt der Aufteilung (S2) des ausgewählten Quantenschaltkreises in Quantenteilschaltkreise,
- einen ersten Schritt des Umschreibens (S3) der Quantenteilschaltkreise, die vom ausgewählten Quantenprozessor nicht ausführbare Quantengatter umfassen, derart ausgewählt, dass sie nur Quantengatter umfassen, die von dem ausgewählten Quantenprozessor ausführbar sind,
- einen zweiten Schritt des Umschreibens (S5) der Quantenteilschaltkreise durch Anwendung eines simulierten Annealings, um Quantenteilschaltkreise zu erhalten, die Quantengatter umfassen, die von dem ausgewählten Quantenprozessor ausführbar sind, wodurch die Anzahl der Quantengatter verringert wird,
- einen Schritt der Zusammenfassung (S6) der Quantenteilschaltkreise zu einem kompilierbaren Quantenschaltkreis für den ausgewählten Quantenprozessor, wobei der zweite Umschreibeschritt umfasst:
- eine Iterationsschleife, die nacheinander umfasst:

* einen Schritt zum Erhalten (S4) von Quantenteilschaltkreisen, die aus dem ersten Umschreibeschritt (S3) stammen,
* einen Schritt des Umschreibens (S5) der Quantenteilschaltkreise in Quantenteilschaltkreise, die Quantengatter umfassen, die von dem Quantenprozessor ausführbar sind und die Anzahl der Quantengatter reduzieren,
* einen Schritt der Zusammenfassung (S6) der Quantenteilschaltkreise, um einen kompilierbare Quantenschaltkreis zu erhalten,
* einen Rückkopplungsschritt, mittels simulierten Annealings, der zu einem neuen Schritt des Umschreibens der aus dem ersten Umschreibeschritt stammenden Quantenteilschaltkreise in Abhängigkeit von der Anzahl der Quantengatter des kompilierbaren Quantenschaltkreises führt, bis zum Erhalt:

° entweder eines extremen Score-Schwellenwertes einer Metrik zur Reduzierung der Anzahl der Quantengatter,
∘ oder eines maximalen Schwellenwertes für Iterationen in der Schleife,

→ eine Iteration der folgenden Schritte:

- ein Schritt zur Simulation der Implementierung (S8) der logischen Qubits des im vorherigen Schritt erhaltenen Quantenschaltkreises auf den physischen Qubits des ausgewählten Quantenprozessors,
- einen Schritt der Erkennung (S9) der ineffizienten Quantengatter in dem Quantenschaltkreis, wobei ineffiziente Quantengatter solche Quantengatter sind, die nicht zwischen zwei Qubits interagieren können, da die Qubits nicht benachbart sind,
- einen Schritt des Einfügens (S10) von Permutationsquantengattern in den Quantenschaltkreis, damit alle Quantengatter des Schaltkreises wirksam sind, d.h. bei dem Quantenschaltkreis wirken dann alle Quantengatter auf zwei benachbarte Qubits,
- einen Schritt der Transformation (S11) des Quantenschaltkreises, wobei ein simuliertes Annealing eine globale Optimierung des Schaltkreises durchführt, um eine globale Metrik einzuhalten, d. h. die Anzahl der Permutationsquantengatter zu minimieren,
- einen Schritt des Bestimmens (S12), ob eine Mindestanzahl von Permutationsquantengattern oder ob eine maximale Anzahl von Iterationen erreicht wird:

° wenn dies der Fall ist, ist der erhaltene Quantenschaltkreis durch den ausgewählten Quantenprozessor ausführbar,
° wenn dies nicht der Fall ist, wird die Methode ab dem Implementierungssimulationsschritt (S8) wiederholt.

2. Methode zur Entwicklung eines Verfahrens zum Kompilieren eines Quantenschaltkreises auf einem Quantensimulator gemäß Anspruch 1, wobei das simulierte Annealing den Quantenschaltkreis umschreibt, indem es:

- die sequenzielle Reihenfolge der Quantengatter der Quantenschaltkreise ändert,
- und/oder mehrere Quantengatter zu einem einzigen Quantengatter verschmilzt,
- und/oder Quantengatter mit einem Qubit oder mehr als zwei Qubits durch Quantengattern mit einem Qubit ersetzt.

**Claims**

1. Computer-implemented method for developing a method for compiling a quantum circuit for a quantum processor, comprising:

   - a step (S1) for selecting:

     * a quantum circuit,
     * a quantum processor on which the quantum circuit is executed,
     * a set of quantum gates executable on the selected quantum processor, according to the selected quantum processor,

   - a step (S2) of dividing the quantum circuit selected into quantum sub-circuits,
   - a first step (S3) of rewriting the quantum sub-circuits comprising quantum gates not executable by the selected quantum processor so that they comprise only quantum gates executable by the selected quantum processor,
   - a second step (S5) of rewriting the quantum sub-circuits, by applying a simulated annealing, so as to obtain quantum sub-circuits comprising quantum gates executable by the selected quantum processor reducing the number of quantum gates,
   - a step (S6) of grouping the quantum sub-circuits in a quantum circuit compilable for the selected quantum processor, wherein the second rewriting step comprises:
   - a loop of iterations comprising successively:

     * a step (S4) of obtaining quantum sub-circuits resulting from the first rewriting step (S3),
     * a step (S5) of rewriting said quantum sub-circuits as quantum sub-circuits comprising quantum gates executable by the quantum processor and reducing the number of quantum gates,
     * a step (S6) of grouping the quantum sub-circuits to obtain a compilable quantum circuit,
     * a feedback step, by means of the simulated annealing, giving rise to a new step of rewriting the quantum sub-circuits resulting from the first rewriting step according to the number of quantum gates of the compilable quantum circuit, until the following are reached:

       ◦ either an extreme score threshold of a metric for reducing the number of quantum gates,
       ◦ or a maximum threshold of iterations in the loop,

   ➢ an iteration of the following steps:

       - a step (S8) of simulating the implementation of the logic qubits of the quantum circuit obtained at the previous step on the physical qubits of the selected quantum processor,
       - a step (S9) of detecting, in the quantum circuit, ineffective quantum gates, the ineffective quantum gates being quantum gates which, having to interact with two qubits, cannot do so, since the qubits are not adjacent,
       - a step (S10) of inserting permutation quantum gates in the quantum circuit so that all the quantum gates of the circuit are effective, i.e. the quantum circuit then has all its quantum gates acting on two adjacent qubits,
       - a step (S11) of transforming the quantum circuit in which a simulated annealing implements a global optimisation of the circuit to respect a global metric, namely minimising the number of permutation quantum gates,
       - a step (S12) of determining whether a minimum number of permutation quantum gates is reached, or whether a maximum number of iterations is reached:

         o if such is the case, the quantum circuit obtained is then executable by the selected quantum processor,
         o if such is not the case, the method is repeated from the implementation simulation step (S8).

2. Method for developing a method for compiling a quantum circuit on a quantum processor according to claim 1, wherein the simulated annealing rewrites the quantum sub-circuits by:

   - changing the sequential order of the quantum gates of the quantum sub-circuits,
   - and/or merging a plurality of quantum gates into a single quantum gate,
   - and/or replacing quantum gates with one qubit or more than two cubits by quantum gates with one qubit.

**B2**

Circuit
+
Métriques

**B1**

Recuit simulé

**B5**

Circuit
optimisé
et/ou
compilé

**B4**

Optimisation locale

**B3**

Recherche locale
- Réécriture de patterns
- Suppressions de portes quantiques
- Nnisation de portes
- ...

Contraintes hardware / règles de réécriture

# FIG. 1

**FIG. 2a**

Sélection de paramètres — S1

Division du circuit quantique en sous-circuits quantiques — S2

Première réécriture des sous-circuits quantiques pour qu'ils ne comprennent que des portes quantiques exécutables — S3

Obtention des sous-circuits réécrits — S4

Deuxième réécriture des sous-circuits quantiques pour qu'ils comprennent des portes quantiques exécutables réduisant le nombre de portes quantiques — S5

Regroupement de ces sous-circuits — S6

S7

NON ◄ Score de la métrique ou nombre d'itérations atteint ?

OUI

Vers Fig. 2b

De Fig. 2a

Simulation de l'implantation des qbits logiques sur le qbits physiques du processeur quantiques — S8

Détection des portes quantiques inefficaces — S9

Insertion des portes quantiques de permutation pour que toutes les portes quantiques soient efficaces — S10

Transformation du circuit quantique par le circuit simulé — S11

S12

Nombre minimal de portes de permutation ou seuil maximal d'itérations atteint ?

NON

OUI

obtention du circuit quantique — S13

FIG. 2b

**Algorithme 1 : Optimisation locale**

changements_possibles : = list < gain, membre droit, membre gauche >

init(changements_possibles)

*while* changement_local_possible() :

trier_par_gain_décroissant(changements_possibles)

*for* membre_droit, membre_gauche in changements_possibles :

remplacer(membre_gauche, membre_droit)

# FIG. 3

# FIG. 4

FIG. 5

FIG. 6

FIG. 7

FIG. 8

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- *Rule-based optimization of reversible circuits*
- **HÄNER et al.** A software methodology for compiling quantum programs. *Quantum Science and Technology*, 21 February 2018, vol. 3 (2), 020501
- Quantum Circuit Simplification and Level Compaction. **MASLOV et al.** arxiv.org. Cornell University Library, 27 February 2008
- **ZULEHNER et al.** Compiling SU(4) Quantum Circuits to IBM QX Architectures. *Corr (Arxiv)*, 05 November 2018, vol. 1808 (v2), 1-6
- Compiling quantum algorithms for architectures with multi-qubit gates. **MARTINEZ et al.** New Journal of Physics. Institute of Physics Publishing, 24 June 2016, vol. 18, 63029

- Tackling the Qubit Mapping Problem for NISQ-Era Quantum Devices. **LI et al.** arxiv.org. Cornell University Library, 07 September 2018
- Synthesis and Optimization of Reversible Circuits - A Survey. **SAEEDI et al.** arxiv.org. Cornell University Library, 12 October 2011
- **AMY et al.** Algorithms for the optimization of quantum circuits. University of Waterloo, 30 August 2013
- Qubit Allocation for Noisy Intermediate-Scale Quantum Computers. **WILL FINIGAN et al.** arxiv.org. Cornell University Library, 19 October 2018
- Quantum-assisted quantum compiling. **SUMEET KHATRI et al.** arxiv.org. Cornell University Library, 02 July 2018